# FASCICULE DE BREVET EUROPEEN

(11) **EP 0 886 406 B1**
(45) Date de publication et mention de la délivrance du brevet: **05.09.2001**
(21) Numéro de dépôt: 98470011.2
(22) Date de dépôt: 18.05.1998
(51) Int. Cl.: H04L 25/02, H03F 3/45

(54) **Etage d'entrées différentielles pour réception large bande avec forte réjection de mode commun.**
Differenzeingangsstufe für Breitbandempfang mit hoher Gleichtaktunterdrückung
Differential input stage for wide band reception with high common mode rejection

(30) Priorité: 16.06.1997 FR 9707604
(43) Date de publication de la demande: 23.12.1998
(73) Titulaire: STMicroelectronics S.A., 94250 Gentilly (FR)
(72) Inventeur: Marbot, Roland, 57070 Metz (FR); Lebihan, Jean-Claude, 57070 Metz (FR); Couteaux, Pascal, 57070 Metz (FR); D'Hoe, Michel, 57070 Metz (FR); Mottini, Francis, 57070 Metz (FR); Nezamzadeh, Reza, 57070 Metz (FR); Pierre-Duplessix, Anne, 57070 Metz (FR)
(74) Mandataire: Ballot, Paul Denis Jacques

(56) Documents cités:
- EP-A- 0 512 795
- EP-A- 0 723 352
- WO-A-97/17763
- US-A- 5 574 401
- ABDULKERIM L COBAN ET AL: "LOW-VOLTAGE ANALOG IC DESIGN IN CMOS TECHNOLOGY" IEEE TRANSACTIONS ON CIRCUITS AND SYSTEMS I: FUNDAMENTAL THEORY AND APPLICATIONS, vol. 42, no. 11, 1 novembre 1995, pages 955-958, XP000549483

## Description

L'invention concerne les circuit intégrés comportant un ou plusieurs étages d'entrée différentielle pour réception large bande avec forte réjection de mode commun. Plus particulièrement, l'invention concerne les circuits à faible tension d'alimentation ayant des ports de communication série de type différentiel utilisant des débits binaires élevés.

Les ports séries de type différentiel sont généralement utilisés pour réaliser des liaisons entre différents dispositifs relativement éloignées. Il est expliqué dans le document EP-A-O 723 352 (par la suite nommé D1) un exemple de fonctionnement de ce type de liaison, on se reportera notamment aux figures 1, 2A et 2B de D1 et à la partie de la description s'y rapportant.

Comme expliqué dans D1, il est possible de voir apparaître une tension de mode commun supplémentaire due à une différence de masse entre les dispositifs utilisant ce type de liaison. Cette tension de mode commun peut provoquer des dysfonctionnements si elle se trouve en dehors d'une plage de fonctionnement d'un amplificateur différentiel.

Dans D1, il est proposée une solution améliorant l'art antérieur qui consiste à décaler les signaux différentiels et à attaquer deux étages différentiels l'un avec les signaux décalé et l'autre avec les signaux non décalés. Les étages différentiels sont connectés entre eux à l'aide d'un OU câblé qui fournit une paire de signaux différentiels à un amplificateur différentiel.

Le document WO 97 17763 (D2) dévoile un étage différentiel comportant un circuit d'attaque comportant un premier circuit d'entrée pour fournir une première paire de signaux différentiels lorsque le premier circuit d'entrée reçoit des signaux dans une première plage de tension, et un deuxième circuit d'entrée pour fournir une deuxième paire de signaux différentiels lorsque le deuxième circuit d'entrée reçoit des signaux dans une deuxième plage de tension.

Le dispositif dévoilé par D1 est relativement performant lorsque l'on a une tension de mode commun de type statique ou faiblement variable. Cependant si l'on a une tension de mode commun qui varie fortement par exemple à proximité d'un émetteur HF, on voit apparaître un phénomène de gigue de phase (jitter) qui est dû à la différence des chemins électriques entre les signaux décalés et les signaux non décalés. Ce phénomène de gigue de phase est particulièrement gênant lorsque l'on utilise une fréquence de transmission de l'ordre du GHz.

L'invention propose un nouvel étage d'entrée ayant pour but de remédier au phénomène de gigue de phase. L'invention utilise deux étages en parallèle fonctionnant avec sensiblement les mêmes temps de propagation.

L'invention a pour objet un circuit intégré comportant au moins un étage d'entrées différentielles ayant deux entrées différentielles et une sortie, l'étage d'entrées différentielles comportant un circuit d'attaque et un circuit de mise en forme. Le circuit d'attaque comporte deux entrées connectées aux deux entrées de l'étage d'entrées différentielles, des premiers moyens pour fournir une première paire de signaux différentiels lorsque les entrées reçoivent des signaux dans une première plage de tension et une tension différentielle nulle lorsque les entrées reçoivent des signaux en dehors de la première plage de tension, et des deuxièmes moyens pour fournir une deuxième paire de signaux différentiels lorsque les entrées reçoivent des signaux dans une deuxième plage de tension et une tension différentielle nulle lorsque les entrées reçoivent des signaux en dehors de la deuxième plage de tension, les temps de propagation des premier et deuxième moyens étant sensiblement identiques. Le circuit de mise en forme comporte des moyens pour différentier chacune des deux paires de signaux différentiels et les combiner afin d'obtenir un unique signal de type binaire.

Préférentiellement, les premiers et deuxièmes moyens sont constitués d'amplificateurs différentiels, l'un desdits moyens ayant des transistors d'attaque de type N et l'autre desdits moyens ayant des transistors d'attaque de type P, les transistors étant dimensionnés pour avoir des caractéristiques temporelles équivalentes.

La recombinaison des paires de signaux différentiels peut se faire à l'aide d'une paire d'amplificateurs différentiels de même type qui partagent une charge commune afin de réaliser un OU câblé. Préférentiellement, la recombinaison est dédoublée afin de produire une nouvelle paire différentielle.

L'invention sera mieux comprise et d'autres particularités et avantages apparaîtront à la lecture de la description qui va suivre, faite en référence aux dessins annexés parmi lesquels:
- la figure 1 représente le mode de réalisation préféré de l'invention,
- les figures 2 et 3 représentent un mode réalisation préféré des amplificateurs différentiels des premiers et deuxièmes moyens,
- la figure 4 représente la paire d'amplificateurs différentiels servant à recombiner les paires de signaux différentiels, et
- la figure 5 représente une variante de réalisation du circuit d'attaque.

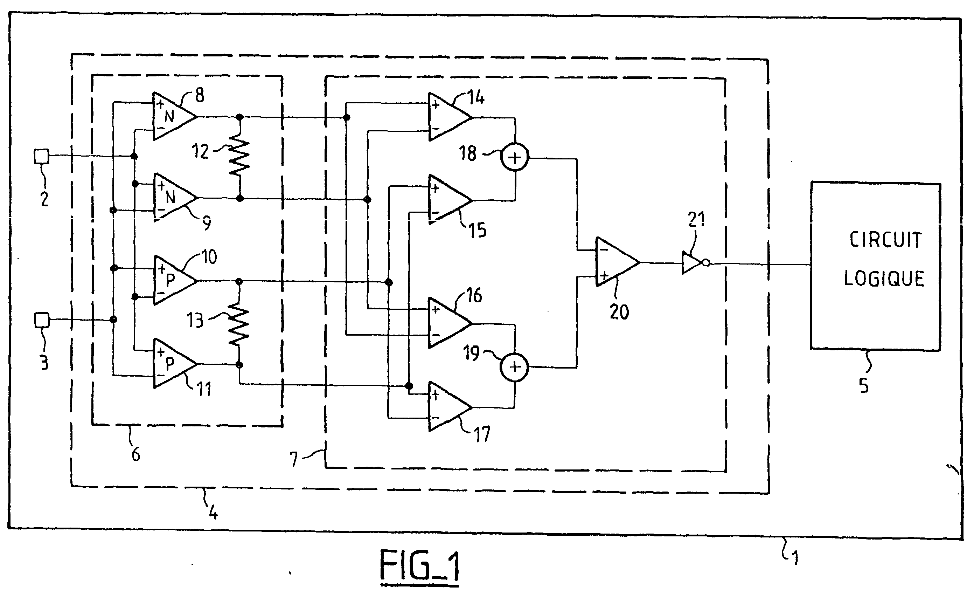

Sur la figure 1 est représenté un circuit intégré 1 qui comporte entre autre des premier et deuxième plots d'entrées 2 et 3, un étage d'entrées différentielles 4 et un circuit logique 5. Bien entendu, le circuit intégré 1 comporte d'autres bornes d'entrée et de sortie et la partie logique 5 peut être de n'importe quel type. Par ailleurs, le circuit intégré 1 peut comporter plusieurs étages d'entrées différentielles ainsi que d'autres éléments qui sont indépendants de l'invention.

Les premier et deuxième plots d'entrées 2 et 3 sont connectés extérieurement à des fils de liaison qui transportent une paire de signaux différentiels. L'étage d'entrée différentiel possède deux entrées et une sortie, les entrées étant connectées aux plots d'entrées 2 et 3, et la sortie étant connectée au circuit logique 5. L'étage d'entrées différentielles comporte en outre un circuit d'attaque 6 et d'un circuit de mise en forme 7.

Le circuit d'attaque 6 dispose de deux entrées qui sont confondues avec les entrées de l'étage différentiel 4 et connectées aux plots d'entrée 2 et 3, et de quatre sorties regroupées en première et deuxième paires de signaux différentiels qui sont fournies au circuit de mise en forme 7. Le circuit de mise en forme 7 dispose en outre d'une sortie qui est confondue avec la sortie de l'étage d'entrée différentiel 4.

Le circuit d'attaque 6 comporte des premier, deuxième, troisième et quatrième amplificateurs différentiels 8 à 11 qui disposent chacun d'une entrée non-inverseuse, d'une entrée inverseuse, et d'une sortie. Les entrées non-inverseuses des premier et troisième amplificateurs 8 et 10 et les entrées inverseuses des deuxième et quatrième amplificateurs 9 et 11 sont connectées au premier plot d'entrée 2. Les entrées inverseuses des premier et troisième amplificateurs 8 et 10 et les entrées non-inverseuses des deuxième et quatrième amplificateurs 9 et 11 sont connectées au deuxième plot d'entrée 3. Les premier et deuxième amplificateurs 8 et 9 forment des premiers moyens qui fournissent la première paire de signaux différentiels. Les troisième et quatrième amplificateurs 10 et 11 forment des deuxièmes moyens qui fournissent la deuxième paire de signaux différentiels.

Les premier et deuxième amplificateurs 8 et 9 fonctionnent chacun sur une première plage de tension comprise par exemple entre une tension sensiblement égale à la tension de seuil d'un transistor MOS et une tension supérieure à la tension d'alimentation. Dans la pratique, la borne supérieure est de l'ordre du volt au dessus de la tension d'alimentation et est fixée par les dispositifs de protection du circuit intégré 1. Les troisième et quatrième amplificateurs 10 et 11 fonctionnent chacun sur une deuxième plage de tension comprise par exemple entre une tension sensiblement égale à la tension d'alimentation moins une tension de seuil d'un transistor MOS et une tension inférieure à 0 V. Dans la pratique, la borne inférieure est de l'ordre du volt en dessous de 0 V et est fixée par les dispositifs de protection du circuit intégré 1.

Lorsque les entrées des premier à quatrième amplificateurs 8 à 11 sont en dehors de leur plage de fonctionnement, la tension de sortie est indéterminée. Pour remédier à un éventuel dysfonctionnement, des première et deuxième charges 12 et 13, de type résistives, sont placées respectivement entre les sorties des premier et deuxième amplificateurs 8 et 9, et entre les sorties des troisième et quatrième amplificateurs 10 et 11. Le rôle joué par les charges 12 et 13 est de ramener les tensions différentielles entre les sorties des premier et deuxième amplificateurs 8 et 9 et entre les sorties des troisième et quatrième amplificateurs 10 et 11 à une tension nulle lorsque les sorties des dits amplificateurs 9 à 11 sont dans un état indéterminé.

Le circuit de mise en forme comporte des cinquième, sixième, septième et huitième amplificateurs 14 à 17 ayant chacun une entrée inverseuse et une entrée non-inverseuse et une sortie. Les cinquième à huitième amplificateurs 14 à 17 sont tous d'un même type. L'entrée non-inverseuse du cinquième amplificateur 14 et l'entrée inverseuse du septième amplificateur 16 sont connectées à la sortie du premier amplificateur 8 pour recevoir l'un des signaux de la première paire de signaux différentiels. L'entrée inverseuse du cinquième amplificateur 14 et l'entrée non-inverseuse du septième amplificateur 16 sont connectées à la sortie du deuxième amplificateur 9 pour recevoir l'autre des signaux de la première paire de signaux différentiels. L'entrée non-inverseuse du sixième amplificateur 15 et l'entrée inverseuse du huitième amplificateur 17 sont connectées à la sortie du troisième amplificateur 10 afin de recevoir l'un des signaux de la deuxième paire de signaux différentiels. L'entrée inverseuse du sixième amplificateur 15 et l'entrée non-inverseuse du huitième amplificateur 17 sont connectées à la sortie du quatrième amplificateur 11 pour recevoir l'autre des signaux de la deuxième paire de signaux différentiels.

Les cinquième et sixième amplificateurs 14 et 15 constituent des moyens pour différentier les première et deuxième paires de signaux différentiels. Il en est de même pour les septième et huitième amplificateurs 16 et 17 qui ont leurs entrées respectivement inversées par rapport aux cinquième et sixième amplificateurs 14 et 15 afin de produire des signaux complémentaires.

Des premier et deuxième dispositifs d'addition de signal 18 et 19 ayant chacun deux entrées et une sortie sont connectées aux sorties des cinquième à huitième amplificateurs 14 à 17 afin d'additionner respectivement les signaux provenant des cinquième et sixième amplificateurs 14 et 15 et des septième et huitième amplificateurs 16 et 17, le premier dispositif d'addition 18 produisant un signal binaire représentatif du signal de sortie de l'étage d'entrée, et le deuxième dispositif d'addition 19 produisant un signal binaire complémentaire représentatif du complément du signal de sortie de l'étage d'entrée.

Le circuit de mise en forme 7 comporte également un neuvième amplificateur 20, ayant deux entrées, dont l'une est inverseuse et une sortie, son entrée inverseuse étant connectée à la sortie du premier dispositif d'addition 18 et son entrée non-inverseuse étant connectée à la sortie du deuxième dispositif d'addition 19. Le neuvième amplificateur 20 sert à différentier le signal binaire et le signal binaire complémentaire. La sortie de ce neuvième amplificateur 20 n'étant pas forcément compatible avec le circuit logique 5, on place sur sa sortie un inverseur à seuil 21 qui a pour but de fournir le signal de sortie sur la sortie de l'étage d'entrée 4. le seuil de l'inverseur à seuil 21 est déterminé pour correspondre sensiblement à la tension de sortie du neuvième amplificateur 20 lorsque les entrées du dit amplificateur 20 sont au même potentiel.

De nombreuses variantes de l'étage d'entrée 4 sont possibles. Dans notre exemple préféré, le circuit d'attaque utilise quatre amplificateurs 8 à 11, il est évident que l'homme du métier peut trouver des dispositifs équivalents qui pourront être décomposés en premiers moyens pour fournir une première paire de signaux différentiels lorsque les entrées reçoivent des signaux dans une première plage de tension et en deuxièmes moyens pour fournir une deuxième paire de signaux différentiels lorsque les entrées reçoivent des signaux dans une deuxième plage de tension sans changer l'objet de l'invention pourvu que les temps de propagation des premier et deuxième moyens soient sensiblement identiques.

De même, le circuit de mise en forme 7 doit comporter des moyens pour différentier chacune des deux paires de signaux différentiels et les combiner afin d'obtenir un unique signal de type binaire. Par exemple, Il est possible de n'utiliser que les cinquième et sixième amplificateur 14 et 15 et le dispositif d'addition 18 en reliant la sortie du dispositif d'addition 18 à la sortie de l'étage d'entrée 4 par l'intermédiaire de l'inverseur à seuil 21 sans utiliser de neuvième amplificateur 20. La redondance apportée par les septième et huitième amplificateurs 16 et 17 sert à éliminer d'éventuelles disparités de fonctionnement des premiers et deuxièmes moyens du circuit d'attaque 6.

De plus, si l'on utilise un circuit logique 5 qui utilise une logique différentielle, il est possible de dupliquer la sortie de l'étage d'entrée en utilisant un amplificateur supplémentaire identique au neuvième amplificateur 20 dont les entrées sont connectées de manière inversée par rapport au dit amplificateur 20.

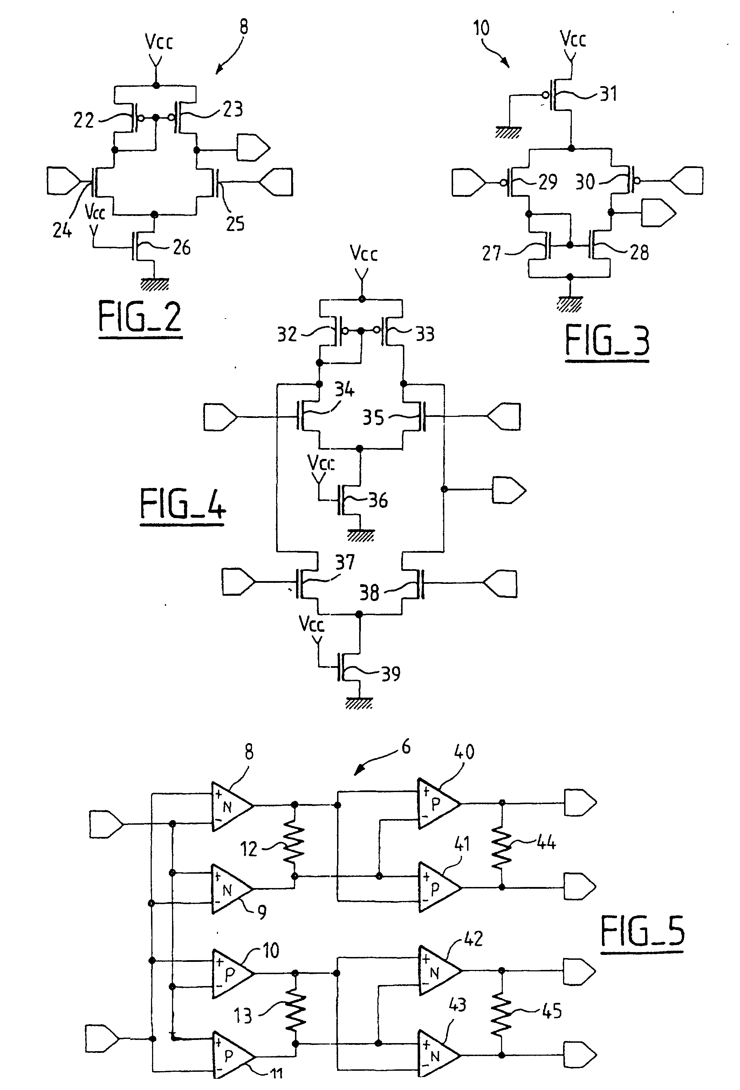

Les figures 2 à 4 vont permettre à l'homme du métier de réaliser au mieux les amplificateurs utilisés dans l'invention.

La figure 2 représente la structure des premier et deuxième amplificateurs 8 et 9. L'amplificateur 8 comporte des premier et deuxième transistors 22 et 23 MOS à canal P et des troisième, quatrième et cinquième transistors 24 à 26 MOS à canal N. Les premier et deuxième transistors 22 et 23 forment un miroir de courant, le deuxième transistor 23 recopiant le courant traversant le premier transistor 22. Les troisième et quatrième transistors 24 et 25 sont les transistors d'attaque de l'amplificateur 8, leurs drains étant respectivement connectés aux drains des premier et deuxième transistor 22 et 23, leurs sources étant connectées ensemble au drain du cinquième transistor 26, et leurs grilles correspondant respectivement l'entrée non-inverseuse et l'entrée inverseuse de l'amplificateur 8. Le cinquième transistor 26 sert à polariser l'amplificateur 8, sa grille est connectée à la tension d'alimentation et sa source est connectée à la masse. La sortie de l'amplificateur 8 correspond au noeud formé par la connexion des drains des deuxième et quatrième transistors 23 et 25.

L'amplificateur 8 fournit en sortie une tension dépendante des entrées. Si une charge résistive est connectée à la sortie, la tension de sortie est proportionnelle à la différence de tension entre les deux entrées. Si aucune charge n'est mise en sortie, la sortie est égale soit à la tension d'alimentation soit à 0 V. Le fonctionnement d'un tel amplificateur 8 est bien connu de l'homme du métier qui sait que si la tension sur les deux entrées est en dessous d'une tension égale à environ une tension de seuil d'un transistor MOS la sortie est dans un état flottant. L'homme de métier sait aussi que si la tension présente sur les deux entrées dépasse la tension d'alimentation, l'amplificateur 8 fonctionne encore correctement (dans une limite de tension non destructrice). Dans notre exemple, on utilise une tension d'alimentation de 3 V, ce qui correspond à une première plage de tension comprise entre environ 1 V et environ 4 V.

La figure 3 représente la structure des troisième et quatrième amplificateurs 10 et 11. L'amplificateur 10 comporte des sixième et septième transistors 27 et 28 MOS à canal N et des huitième, neuvième et dixième transistors 29 à 31 MOS à canal P. Les sixième et septième transistors 17 et 28 forment un miroir de courant, le septième transistor 28 recopiant le courant traversant le sixième transistor 27. Les huitième et neuvième transistors 29 et 30 sont les transistors d'attaque de l'amplificateur 10, leurs drains étant respectivement connectés aux drains des sixième et septième transistors 27 et 28, leurs sources étant connectées ensemble au drain du cinquième transistor 31, et leurs grilles correspondant respectivement l'entrée inverseuse et l'entrée non-inverseuse de l'amplificateur 10. Le cinquième transistor 31 sert à polariser l'amplificateur 10, sa grille est connectée à la masse et sa source est connectée à la tension d'alimentation. La sortie de l'amplificateur 10 correspond au noeud formé par la connexion des drains des septième et huitième transistors 28 et 30.

L'amplificateur 10 fonctionne de manière analogue à l'amplificateur 8. L'homme du métier sait que si la tension présente sur les deux entrées est au dessus d'une tension égale à environ la tension d'alimentation moins une tension de seuil d'un transistor MOS la sortie est dans un état flottant. L'homme de métier sait aussi que si la tension présente sur les deux entrées est inférieure à 0 V, l'amplificateur 10 fonctionne encore correctement (dans une limite de tension non destructrice). Dans notre exemple, la deuxième plage de tension est comprise entre environ -1 V et environ 2 V.

Pour que les premier à quatrième amplificateurs 8 à 11 aient des temps de propagation équivalent, il suffit de dimensionner les transistors à canal N et P ayant une fonction équivalente entre les figures 1 et 2 pour que les caractéristiques temporelles desdits transistors soient similaires. Ainsi, les premier et deuxième transistors 22 et 23 doivent être appareillés avec les sixième et septième transistors 27 et 28; les troisième et quatrième transistors 24 et 25 doivent être appareillés avec les huitième et neuvième transistors 29 et 30; et le cinquième transistor 26 doit être appareillé avec le dixième transistor 31. L'appareillage correspond à un rapport de surface des transistors qui prend en compte la mobilité des porteurs de chaque type de dopant. A titre d'exemple, avec un procédé CMOS standard, on doit avoir une largeur d'un transistor à canal P environ 2,5 fois plus importante que la largeur d'un transistor à canal N de même longueur pour que les transistors soient équivalents.

Les circuits des figures 2 et 3 sont équivalents mais cependant ils présentent des disparités de fonctionnement. Une première disparité est due aux tolérances sur les dopages lors de la fabrication des circuits. Une deuxième disparité vient de la connexion des sorties des premier à quatrième amplificateurs 8 à 11 par l'intermédiaire des charges résistives 12 et 13. Un effet secondaire de l'utilisation d'amplificateurs complémentaires est de faire intervenir des tensions de mode commun aux sorties des premier et deuxième amplificateurs 8 et 9 et aux sorties des troisième et quatrième amplificateurs 10 et 11 qui sont différents suivant le type d'amplificateur. Ces tensions de mode commun dépendent, d'une part, de la tension de mode commun sur les entrées et, d'autre part, de la constitution des amplificateurs.

Ces disparités de fonctionnement créent un effet de gigue de phase au niveau des cinquième et sixième amplificateurs 14 et 15. L'ajout des septième et huitième amplificateurs 16 et 17 permet de compenser ce phénomène. L'homme du métier peut remarquer cependant que la gigue de phase créée par les disparités de fonctionnement des premier à quatrième amplificateurs 8 à 11 est nettement moins importante que ce qui existait dans l'état de la technique. Il n'est pas nécessaire de compenser cette gigue si le résultat obtenu est suffisant (suivant la destination du circuit).

Sur la figure 4, il est représenté un mode de réalisation préféré des cinquième et sixième amplificateurs 14 et 15 et du premier dispositif d'addition 18. Sur cette figure 4, les cinquième et sixième amplificateurs 14 et 15 partagent une charge commune qui additionne les signaux de sortie desdits cinquième et sixième amplificateurs 14 et 15 en réalisant un OU câblé.

Le circuit de la figure 4 comporte des onzième et douzième transistors 32 et 33 MOS à canal P et des treizième à dix-huitième transistors 34 à 39 MOS à canal N. Les onzième et douzième transistors 32 et 33 forment un miroir de courant, le douzième transistor 33 recopiant le courant traversant le onzième transistor 32. Les treizième et quatorzième transistors 34 et 35 sont les transistors d'attaque du cinquième amplificateur 14, leurs drains étant respectivement connectés aux drains des onzième et douzième transistors 32 et 33, leurs sources étant connectées ensemble au drain du quinzième transistor 36, et leurs grilles correspondant respectivement l'entrée non-inverseuse et l'entrée inverseuse de l'amplificateur 14. Le quinzième transistor 36 sert à polariser l'amplificateur 14, sa grille est connectée à la tension d'alimentation et sa source est connectée à la masse. Les seizième et dix-septième transistors 37 et 38 sont les transistors d'attaque du sixième amplificateur 15, leurs drains étant respectivement connectés aux drains des onzième et douzième transistors 32 et 33, leurs sources étant connectées ensemble au drain du dix-huitième transistor 39, et leurs grilles correspondant respectivement l'entrée non-inverseuse et l'entrée inverseuse de l'amplificateur 15. Le dix-huitième transistor 36 sert à polariser l'amplificateur 15, sa grille étant connectée à la tension d'alimentation et sa source étant connectée à la masse. Les sorties des cinquième et sixième amplificateurs 14 et 15 correspondent au noeud formé par la connexion des drains des douzième, quatorzième et dix-septième transistors 33, 35 et 38.

Le circuit de la figure 4 fonctionne de la même manière que le circuit de la figure 2. L'homme du métier peut remarquer que l'utilisation d'un unique miroir de courant revient à additionner les courants qui devrait sortir de deux amplificateurs du type de la figure 2. Etant donné que ce montage attaque directement des grilles de transistor MOS, la tension de sortie est déterminée par la charge d'une capacité équivalente aux grilles des transistors attaqués.

Le schéma de la figure 5 présente une variante du circuit d'attaque 6 qui présente moins de disparité de fonctionnement. Le circuit d'attaque de la figure 5 comporte les premier à quatrième amplificateurs 8 à 11, les première et deuxième charges résistives 12 et 13, des dixième à treizième amplificateurs 40 à 43, et des troisième et quatrième charges résistives 44 et 45. Les dixième et onzième amplificateurs 40 et 41 sont identiques aux troisième et quatrième amplificateurs 10 et 11. Les douzième et treizième amplificateurs 42 et 43 sont identiques aux premier et deuxième amplificateurs 8 et 9. Les troisième et quatrième charges résistives 44 et 45 sont identiques aux première et deuxième charges résistives 12 et 13.

Les premier à quatrième amplificateurs 8 à 11 et les première et deuxième charges résistives sont connectées comme précédemment indiqué afin de fournir des première et deuxième paire de signaux différentiels intermédiaires. L'entrée non-inverseuse du dixième amplificateur 40 et l'entrée inverseuse du onzième amplificateur 41 sont connectées à la sortie du premier amplificateur 8. L'entrée inverseuse du dixième amplificateur 40 et l'entrée non-inverseuse du onzième amplificateur 41 sont connectées à la sortie du deuxième amplificateur 9. L'entrée non-inverseuse du douzième amplificateur 42 et l'entrée inverseuse du treizième amplificateur 43 sont connectées à la sortie du troisième amplificateur 10. L'entrée inverseuse du douzième amplificateur 42 et l'entrée non-inverseuse du treizième amplificateur 43 sont connectées à la sortie du quatrième amplificateur 11. Les dixième et onzième amplificateurs 40 et 41 forment des troisièmes moyens qui fournissent la première paire de signaux différentiels en sortie du circuit d'attaque 6, et les douzième et treizième amplificateurs 42 et 43 forment des quatrièmes moyens qui fournissent la deuxième paire de signaux différentiels en sortie du circuit d'attaque 6. Les troisième et quatrième charges 44 et 45 sont placées respectivement entre les sorties des dixième et onzième amplificateurs 40 et 41, et entre les sorties des douzième et treizième amplificateurs 42 et 43.

Le circuit d'attaque 6 de la figure 5 effectue une compensation des disparités de fonctionnement des premier à quatrième amplificateurs 8 à 11. Les disparités dues aux tolérances de fabrication sont supprimés car les deux paires de signaux différentiels traversent des amplificateurs de même nature (un de type P et un de type N). De plus, la tension de mode commun en sortie des dixième à treizième amplificateurs 40 à 43 dépend moins fortement de la tension de mode commun présente sur les première et deuxième bornes d'entrée 2 et 3. La gigue venant des disparité de fonctionnement étant fortement diminuée, il est possible de supprimer les septième à neuvième amplificateurs 16, 17 et 20 du circuit de mise en forme 7. Néanmoins, dans notre exemple qui utilise des charges résistives en sortie des amplificateurs du circuit d'attaque 6, le circuit de la figure 5 présente des temps de propagation un peu élevés et un encombrement important. Le circuit de la figure 5 peut cependant être très intéressant dans certaines applications.

Ce circuit de la figure 5 peut être transposé à des circuits d'attaque 6 n'utilisant pas d'amplificateurs mais des premiers et deuxièmes moyens qui fournissent des première et deuxième paires de signaux différentiels intermédiaire, les premier et deuxième moyens fonctionnant respectivement dans des première et deuxième plages de tension et ayant des temps de propagation sensiblement identiques. La compensation des premiers et deuxièmes moyens s'effectuant par l'ajout de troisièmes moyens identiques aux deuxièmes moyens dont les entrées sont connectées aux sorties des premiers moyens afin de fournir la première paire de signaux différentiels, et par l'ajout de quatrièmes moyens identiques aux premiers moyens dont les entrées sont connectées aux sorties des deuxièmes moyens afin de fournir la deuxième paire de signaux différentiels.

## Revendications

1. Circuit intégré (1) comportant au moins un étage d'entrées différentielles (4) ayant deux entrées différentielles (2, 3) et une sortie, l'étage d'entrées différentielles (4) comportant un circuit d'attaque (6) et un circuit de mise en forme (7), le circuit d'attaque (6) comportant deux entrées connectées aux deux entrées de l'étage d'entrées différentielles (4), des premiers moyens (8, 9, 12) pour fournir une première paire de signaux différentiels lorsque les entrées reçoivent des signaux dans une première plage de tension, et des deuxièmes moyens (10, 11, 13) pour fournir une deuxième paire de signaux différentiels lorsque les entrées reçoivent des signaux dans une deuxième plage de tension,
le circuit intégré étant **caractérisé en ce que** les premiers moyens (8, 9, 12) fournissent une tension différentielle nulle lorsque les entrées reçoivent des signaux en dehors de la première plage de tension, et en ce que les deuxièmes moyens (10, 11, 13) fournissent une tension différentielle nulle lorsque les entrées reçoivent des signaux en dehors de la deuxième plage de tension, les temps de propagation des premier et deuxième moyens étant sensiblement identiques.

2. Circuit selon la revendication 1, **caractérisé en ce que** le circuit de mise en forme (7) comporte des moyens (14, 15, 18) pour différentier chacune des deux paires de signaux différentiels et les combiner afin d'obtenir un unique signal de type binaire.

3. Circuit selon l'une des revendications 1 ou 2,
**caractérisé en ce que** les premier moyens comportent des premier et deuxième amplificateurs (8, 9) ayant chacun une entrée inverseuse, une entrée non-inverseuse et une sortie, l'entrée non-inverseuse du premier amplificateur (8) et l'entrée inverseuse du deuxième amplificateur (9) étant connectées à une première desdites deux entrées, l'entrée inverseuse du premier amplificateur (8) et l'entrée non-inverseuse du deuxième amplificateur (9) ètant connectées à une deuxième desdites deux entrées, les premier et deuxième amplificateurs (8, 9) étant d'un premier type fonctionnant dans la première plage de tension,
et en ce que les deuxièmes moyens comportent des troisième et quatrième amplificateurs (10, 11) ayant chacun une entrée inverseuse, une entrée non-inverseuse et une sortie, l'entrée non-inverseuse du troisième amplificateur (10) et l'entrée inverseuse du quatrième amplificateur (11) étant connectées à la première desdites entrées, l'entrée inverseuse du troisième amplificateur (10) et l'entrée non-inverseuse du quatrième amplificateur (11) étant connectées à la deuxième desdites entrées, les troisième et quatrième amplificateurs (10, 11) étant d'un deuxième type fonctionnant dans une deuxième plage de tension d'entrée.

4. Circuit selon la revendication 3, **caractérisé en ce que** les amplificateurs du premier type (8, 9) ont des transistors d'attaque (24, 25) d'un premier type et les amplificateurs du deuxième type (10, 11) ont des transistors d'attaque (29, 30) d'un deuxième type, et en ce que les transistors (22 à 31) des amplificateurs du premier type (8, 9) et du deuxième type (10, 11) sont dimensionnés pour avoir des temps de propagation équivalents.

5. Circuit selon l'une des revendications 3 ou 4,
**caractérisé en ce que** les sorties des premier et deuxième amplificateurs (8, 9) sont reliées entre elles par l'intermédiaire d'une première charge (12) de type résistive, et en ce que les sorties des troisième et quatrième amplificateurs (10, 11) sont reliées entre elles par l'intermédiaire d'une deuxième charge (13) de type résistive.

6. Circuit selon l'une des revendications 2 à 5,
**caractérisé en ce que** le circuit de mise en forme (7) comporte des cinquième et sixième amplificateurs (14, 15) ayant chacun une entrée inverseuse et une entrée non-inverseuse et une sortie, l'entrée non-inverseuse du cinquième amplificateur (14) recevant l'un des signaux de la première paire de signaux différentiel, l'entrée inverseuse du cinquième amplificateur (14) recevant l'autre des signaux de la première paire de signaux différentiels, l'entrée non-inverseuse du sixième amplificateur (15) recevant l'un des signaux de la deuxième paire de signaux différentiels, l'entrée inverseuse du sixième amplificateur (15) recevant l'autre des signaux de la deuxième paire de signaux différentiels, et en ce que les sorties des cinquième et sixième amplificateurs (14, 15) sont additionnées et reliées à la sortie de l'étage d'entrée afin de fournir un signal binaire représentatif du signal de sortie de l'étage d'entrée.

7. Circuit selon la revendication 6, **caractérisé en ce que** les cinquième et sixième amplificateurs (14, 15) partage une charge commune (32, 33) qui additionne les signaux de sortie desdits cinquième et sixième amplificateurs (14, 15) en réalisant un OU câblé.

8. Circuit selon l'une des revendications 6 ou 7,
**caractérisé en ce que** le circuit de mise en forme (7) comporte des septième et huitième amplificateurs (16, 17) identiques aux cinquième et sixième amplificateurs (14, 15), les entrées du septième amplificateur (16) étant inversées par rapport au cinquième amplificateur (14) et les entrées du huitième amplificateur (17) étant inversées par rapport au sixième amplificateur (15), les sorties des septième et huitième amplificateurs (16, 17) étant additionnées de la même manière que pour les cinquième et sixième amplificateurs (14, 15) afin de fournir un signal binaire complémentaire représentatif du complément du signal de sortie de l'étage d'entrée.

9. Circuit selon la revendication 8, **caractérisé en ce que** le circuit de, mise en forme (7) comporte un ' neuvième amplificateur (20) ayant deux entrées, dont l'une est inverseuse et une sortie, l'une des entrées recevant le signal binaire et l'autre recevant le signal binaire complémentaire, et en ce que la sortie du neuvième amplificateur (20) est connectée à un inverseur (21) dont le seuil est adapté au neuvième amplificateur (20).

10. Circuit selon l'une des revendications 3 à 9,
**caractérisé en ce que** le circuit d'attaque (6) comporte :
- des troisièmes moyens (40, 41, 44) identiques aux deuxièmes moyens (10, 11, 13) dont les entrées sont connectées aux sorties des premiers moyens (8, 9, 12) afin de fournir la première paire de signaux différentiels; et
- des quatrièmes moyens (42, 43, 45) identiques aux premiers moyens (8, 9, 12) dont les entrées sont connectées aux sorties des deuxièmes moyens (10, 11, 13) afin de fournir la deuxième paire de signaux différentiels.

## Claims

1. Integrated circuit (1) including at least one differential input stage (4) having two differential inputs (2, 3) and one output, the differential input stage (4) including a driver circuit (6) and a shaping circuit (7), the driver circuit (6) having two inputs connected to the two inputs of the differential input stage (4), first means (8, 9, 12) for supplying a first pair of differential signals when the inputs receive signals in a first voltage range, and second means (10, 11, 13) for supplying a second pair of differential signals when the inputs receive signals in a second voltage range,
the integrated circuit being **characterised in that** the first means (8, 9, 12) supply a zero differential voltage when the inputs receive signals outside the first voltage range, and in that the second means (10, 11, 13) supply a zero differential voltage when the inputs receive signals outside the second voltage range, the propagation times of the first and second means being substantially identical.

2. Circuit according to Claim 1, **characterised in that** the shaping circuit (7) has means (14, 15, 18) for differentiating each of the two pairs of differential signals and combining them in order to obtain a single signal of the binary type.

3. Circuit according to one of Claims 1 or 2, **characterised in that** the first means include first and second amplifiers (8, 9) each having an inverting input, a non-inverting input and an output, the non-inverting input of the first amplifier (8) and the inverting input of the second amplifier (9) being connected to a first one of the said two inputs, the inverting input of the first amplifier (8) and the non-inverting input of the second amplifier (9) being connected to a second of said two inputs, the first and second amplifiers (8, 9) being of a first type functioning in the first voltage range,
and in that the second means include third and fourth amplifiers (10, 11) each having an inverting input, a non-inverting input and an output, the non-inverting input of the third amplifier (10) and the inverting input of the fourth amplifier (11) being connected to the first of the said inputs, the inverting input of the third amplifier (10) and the non-inverting input of the fourth amplifier (11) being connected to the second of the said inputs, the third and fourth amplifiers (10, 11) being of a second tape functioning in a second input voltage range.

4. Circuit according to Claim 3, **characterised in that** the amplifiers of the first type (8, 9) have driver transistors (24, 25) of a first type and the amplifiers of the second type (10, 11) have driver transistors (29, 30) of a second type, and in that the transistors (22 t:o 31) of the amplifiers of the first type (8, 9) and of the second type (10, 11) are sized so as to have equivalent propagation times.

5. Circuit according to one of Claims 3 or 4, **characterised in that** the outputs of the first and second amplifiers (8, 9) are connected together by means of a first load (12) of the resistive type, and in that the outputs of the third and fourth amplifiers (10, 11) are connected together by means of a second load (13) of the resistive type.

6. Circuit according to one of Claims 2 to 5, **characterised in that** the shaping circuit (7) has fifth and sixth amplifiers (14, 16) each having an inverting input and a non-inverting input and an output, the non-inverting input of the fifth amplifier (14) receiving one of the signals of the first pair of differential signals, the inverting input of the fifth amplifier (14) receiving the other one of the signals of the first pair of differential signals, the non-inverting input of the sixth amplifier (15) receiving one of the signals of the second pair of differential signals, the inverting input of the sixth amplifier (15) receiving the other one of the signals of the second pair of differential signals, and in that the outputs of the fifth and sixth amplifiers (14, 15) are added and connected to the output of the input stage in order to supply a binary signal representing the output signal of the input stage.

7. Circuit according to Claim 6, **characterised in that** the fifth and sixth amplifiers (14, 15) share a common load (32, 33) which adds the output signals of the said fifth and sixth amplifiers (14, 15) by producing a hard-wired OR.

8. Circuit according to one of Claims 6 or 7, **characterised in that** the shaping circuit (7) includes seventh and eighth amplifiers (16, 17) identical to the fifth and sixth amplifiers (14, 15), the inputs of the seventh amplifier (16) being reversed with respect to the fifth amplifier (14) and the inputs of the eighth amplifier (17) being reversed with respect to the sixth amplifier (15), the outputs of the seventh and eighth amplifiers (16, 17) being added in the same way as with the fifth and sixth amplifiers (14, 15) in order to supply a complementary binary signal representing the complement of the output signal of the input stage.

9. Circuit according to Claim 8, **characterised in that** the shaping circuit (7) includes a ninth amplifier (20) having two inputs, one of which is inverting, and one output, one of the inputs receiving the binary signal and the other receiving the complementary binary signal, and in that the output of the ninth amplifier (20) is connected to an inverter (21) whose threshold is adapted to the ninth amplifier (20).

10. Circuit according to one of Claims 3 to 9, **characterised in that** the driver circuit (6) has:
- third means (40, 41, 44) identical to the second means (10, 11, 13) whose inputs are connected to the outputs of the first means (8, 9, 12) in order to supply the first pair of differential signals; and
- fourth means (42, 43, 45) identical to the first means (8, 9, 12) whose inputs are connected to the outputs of the second means (10, 11, 13) in order to supply the second pair of differential signals.

## Patentansprüche

1. Integrierter Schaltkreis (1) mit wenigstens einer Differenzeingangsstufe (4) mit zwei differentiellen Eingängen (3) und einem Ausgang, wobei die Differenzeingangsstufe (4) einen Eingangsstufenschaltkreis (6) und einen Pulsformerschaltkreis (7) umfaßt, der Eingangsstufenschaltkreis (6) zwei Eingänge umfaßt, die mit den zwei Eingängen der Differenzeingangsstufe (4) verbunden sind, erste Mittel (8, 9, 12) zum Ausgeben eines ersten Differenzsignalpaars, wenn an den Eingängen Signale an dem ersten Spannungsbereich anliegen, und zweite Mittel (10, 11, 13) zum Ausgeben eines zweiten Differenzsignalpaars, wenn an den Eingängen Signale in einem zweiten Spannungsbereich anliegen,
wobei der integrierte Schaltkreis **dadurch gekennzeichnet** ist, daß
die ersten Mittel (8, 9, 12) eine differentielle Spannung 0 ausgeben, wenn an den Eingängen Signale außerhalb des ersten Spannungsbereichs anliegen, und
daß die zweiten Mittel (10, 11, 13) eine differentielle Spannung 0 ausgeben, wenn an den Eingängen Signale außerhalb des zweiten Spannungsbereichs anliegen, wobei die Laufzeiten des ersten und zweiten Mittels im wesentlichen identisch sind.

2. Schaltkreis nach Anspruch 1, **dadurch gekennzeichnet**, daß der Pulsformerschaltkreis (7) Mittel (14, 15, 18) zum Differenzieren jedes der zwei Differenzsignalpaare und zu ihrem Kombinieren umfaßt, um ein einziges Signal binären Typs zu erhalten.

3. Schaltkreis nach einem der Ansprüche 1 oder 2, **dadurch gekennzeichnet**, daß die ersten Mittel einen ersten und einen zweiten Verstärker (8, 9) umfassen, jeweils mit einem invertierenden Eingang, einem nicht-invertierenden Eingang und einem Ausgang, wobei der nicht-invertierende Eingang des ersten Verstärkers 8 und der invertierende Eingang des zweiten Verstärkers (9) mit einem ersten der zwei Eingänge verbunden ist, der invertierende Eingang des ersten Verstärkers (8) und der nicht-invertierende Eingang des zweiten Verstärkers mit einem zweiten der zwei Eingänge verbunden sind, der erste und zweite Verstärker (8, 9) von einem ersten Typ sind, die in dem ersten Spannungsbereich arbeiten,
und daß die zweiten Mittel einen dritten und einen vierten Verstärker (10, 11) umfassen mit jeweils einem invertierenden Eingang, einem nicht-invertierenden Eingang und einem Ausgang, wobei der nicht-invertierende Eingang des dritten Verstärkers (10) und der invertierende Eingang des vierten Verstärkers (11). verbunden sind mit dem ersten der Eingänge, der invertierende Eingang des dritten Verstärkers (10) und der nicht-invertierende Eingang des vierten Verstärkers (11) verbunden sind mit dem zweiten der Eingänge, der dritte und der vierte Verstärker (10, 11) von einem zweiten Typ sind, die in einem zweiten Eingangsspannungsbereich arbeiten.

4. Schaltkreis nach Anspruch 3, **dadurch gekennzeichnet**, daß die Verstärker vom ersten Typ (8, 9) Eingangsstufentransistoren (24, 25) eines ersten Typs umfassen und die Verstärker des zweiten Typs (10, 11) Eingangsstufentransistoren (29, 30) eines zweiten Typs umfassen und daß die Transistoren (22 bis 31) der Verstärker des ersten Typs (8, 9) und des zweiten Typs (10, 11) so ausgelegt sind, daß sie äquivalente Laufzeiten aufweisen.

5. Schaltkreis nach einem der Ansprüche 3 oder 4, **dadurch gekennzeichnet**, daß die Ausgänge des ersten und zweiten Verstärkers (8,9) untereinander über eine erste Last (12) vom Ohmschen Typ verbunden sind und daß die Ausgänge des dritten und vierten Verstärkers (10, 11) miteinander über eine zweite Last (13) vom Ohmschen Typ verbunden sind.

6. Schaltkreis nach einem der Ansprüche 2 bis 5, **dadurch gekennzeichnet**, daß der Pulsformerschaltkreis (7) einen fünften und sechsten Verstärker (14, 15) umfaßt, jeweils mit einem invertierenden Eingang und einem nicht-invertierenden Eingang und einem Ausgang, wobei an dem nicht-invertierenden Eingang des fünften Verstärkers (15) eines der Signale des ersten Differenzsignalpaars anliegt, an dem invertierenden Eingang des fünften Verstärkers (14) das andere Signal des ersten Differenzsignalpaars anliegt, an dem nicht-invertierenden Eingang des sechsten Verstärkers (15) das eine der Signale des zweiten Differenzsignalpaars anliegt, an dem invertierenden Eingang des sechsten Verstärkers (15) das andere der Signale des zweiten Differenzsignalpaars anliegt, und daß die Ausgänge des fünften und sechsten Verstärkers (14, 15) addiert werden und mit dem Ausgang der Eingangsstufe verbunden werden, um ein binäres Signal in Abhängigkeit von dem Ausgangssignal der Eingangsstufe auszugeben.

7. Schaltkreis nach Anspruch 6, **dadurch gekennzeichnet**, daß der fünfte und sechste Verstärker (14, 15) gemeinsam eine gemeinsame Last (32, 33) aufweisen, die die Ausgangssignale des fünften und sechsten Verstärkers (14, 15) durch Bilden eines verdrahteten ODER-Gatters addiert.

8. Schaltkreis nach einem der Ansprüche 6 oder 7, **dadurch gekennzeichnet**, daß der Pulsformerschaltkreis (7) einen siebten und einen achten Verstärker (16, 17) aufweist, die identisch mit dem fünften und sechsten Verstärker (14, 15) sind, wobei die Eingänge des siebten Verstärkers (16) in bezug auf den fünften Verstärkers (15) invertiert sind und die Eingänge des achten Verstärkers (17) in bezug auf den sechsten Verstärker (15) invertiert sind, wobei die Ausgänge des siebten und achten Verstärkers (16, 17) auf die gleiche Art addiert werden, wie bei dem fünften und sechsten Verstärker (14, 15), um ein komplementäres binäres Signal auszugeben, das dem Komplement des Ausgangssignals der Eingangsstufe entspricht.

9. Schaltkreis nach Anspruch 8, **dadurch gekennzeichnet**, daß der Pulsformerschaltkreis (7) einen neunten Verstärker (20) mit zwei Eingängen umfaßt, deren einer invertiert ist, und einen Ausgang, wobei an dem einen der Eingänge das binäre Signal anliegt und an dem anderen das komplementäre binäre Signal anliegt, und daß der Ausgang des neunten Verstärkers (20) mit einem Invertierer (21) verbunden ist, dessen Schwelle dem neunten Verstärker (20) angepaßt ist.

10. Schaltkreis nach einem der Ansprüche 3 bis 9, **dadurch gekennzeichnet**, daß der Eingangsstufenschaltkreis (6) umfaßt:
dritte Mittel (40, 41, 44), die identisch mit den zweiten Mitteln(10, 11, 13) sind, deren Eingänge mit den Ausgängen der ersten Mittel (8, 9, 12) verbunden sind, um das erste Differenzsignalpaar auszugeben, und
vierte Mittel (42, 43, 45), die identisch sind mit den ersten Mitteln (8, 9, 12), deren Eingänge mit den Ausgängen der zweiten Mittel (10, 11, 13) verbunden sind, um das zweite Differenzsignalpaar auszugeben.
